# EUROPEAN PATENT APPLICATION

(11) **EP 0 691 681 A2**
(43) Date of publication of application: **10.01.1996**
(21) Application number: 95304642.2
(22) Date of filing: 03.07.1995
(51) Int. Cl.: H01L 23/433

(54) **Semiconductor packaging**

(30) Priority: 05.07.1994 JP 153169/94
(71) Applicant: INTERNATIONAL BUSINESS MACHINES CORPORATION, Armonk, NY 10504 (US)
(72) Inventor: Hayashida, S., Kohga-gun, Shiga-ken (JP); Umemoto, K., Kusatsu-shi, Shiga-ken (JP)
(74) Representative: Litherland, David Peter

(57) **Abstract**

A heat sink 22 is hydroxulated by degreasing with alkali, cleaning with water and drying, Thereafter, a diluted silane coupling agent is applied to the surface of the heat sink 22, and the heat sink 22 is dried to form a layer A of the silane coupling agent on the surface of the heat sink 22, Then, a chip 12 carried by the die pad 16 and lead frames 18 connected to the chip 12 with wires 20 are placed in the die, the heat sink 22 is placed in the same die, and the system is moulded to form a semiconductor packaging 10. In this manner, heat dissipation characteristics are maintained while reducing manufacturing costs.

## Description

The present invention relates to the field of semiconductor device packages and a method of production thereof.

Heretofore, many semiconductor devices generate heat during operation, and such semiconductor devices are required to be cooled efficiently. Therefore, semiconductor packaging having a structure in which a heat sink for dissipating heat is embedded in the mould encapsulating the semiconductor devices have been known.

Because of the necessity of providing a heat sink in the mould while maintaining adhesion between the heat sink and the mould, and preventing moisture from penetrating through the adhered parts, various methods have been proposed on the manufacture of semiconductor packaging.

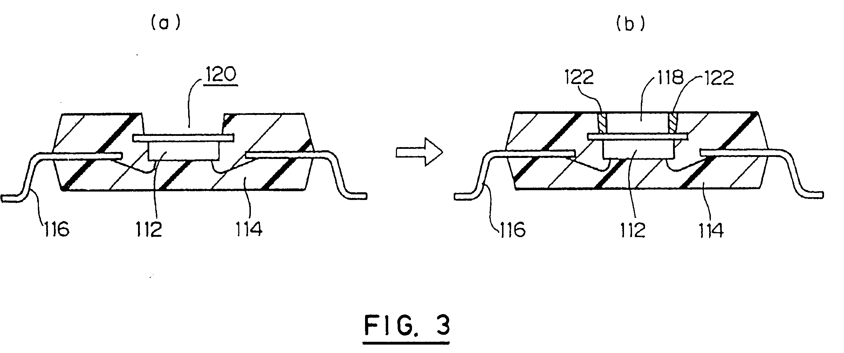

A prior art method for producing a semiconductor packaging will be described with reference to Figures 3 through 5.

For example, as Figure 3(a) shows, a chip 112 connected to lead frames 116 is first encapsulated by moulding a mould 114 provided with a space 120 slightly larger than a heat sink 118. Thereafter, as Figure 3(b) shows, the heat sink 118 is placed in the space 120, and an adhesive resin 122 is poured into the gap between the mould 114 and the heat sink 118 to fix the heat sink 118 in the space 120.

By this first method shown in Figure 3, however, special steps such as placing the heat sink 118 in the space 120 after moulding the mould 114, and pouring the resin 122 between the mould 114 and the heat sink 118, causes the costs for producing semiconductor packaging to increase.

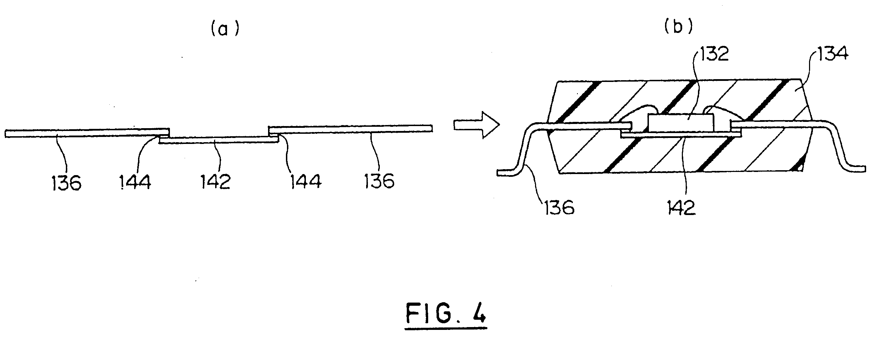

As Figure 4(a) shows, lead frames 136 to which a heat spreader 142 is bonded using double-sided adhesive tapes 144 are treated as ordinary lead frames, and as Figure 4(b) shows, a chip 132 connected to the lead frames 136 is placed on the heat spreader 142, and encapsulated in a mould 134 formed from a resin material.

By this second method shown in Figure 4, however, the production costs of the semiconductor packaging increase due to increase in the costs for the lead frames 136, and the efficiency of heat dissipation is lower than the efficiency of ordinary heat sinks exposed from the semiconductor packaging.

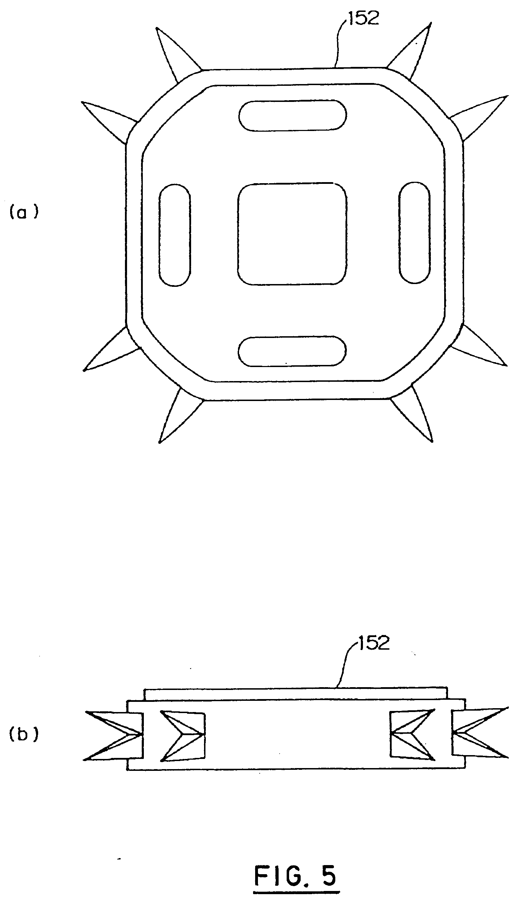

Furthermore, as the third method, a heat sink 152 having the shape as shown in Figure 5 is placed in a die (not shown) and a mould (not shown) is formed to embed the heat sink 152 in the mould.

By the third method, however, the necessity arises for processing the heat sink 152 in a complicated shape as shown in Figure 5 to maintain adhesion between the heat sink 152 and the mould, resulting in increase of the costs for fabricating the heat sink 152, thus elevating the overall manufacturing costs of semiconductor packaging.

In view of the problems described above, it is therefore desirable to provide a semiconductor package which is able to maintain the required amount of heat dissipation for a long period while reducing manufacturing costs, and a method for producing such a semiconductor packaging.

Accordingly, in a first aspect, the present invention provides a method for producing a semiconductor package incorporating at least one semiconductor device comprising the steps of hydroxylating the surface of the metal heat sink for dissipating heat generated by said at least one semiconductor device, then depositing a layer of a silane coupling agent on the surface of said heat sink, and embedding said heat sink in a mould resin by casting a resin material around said heat sink.

In a preferred method the silane coupling agent is selected from the group consisting of γ-aminopropyl-triethoxysilane, N-β-(aminoethyl)-γ-aminopropyl-trimethoxysilane, β-(3,4-epoxy-cyclohexyl)-ethyltrimethoxysilane, and γ-glycidoxy-propyltrimethoxysilane.

It is further preferred that prior to the application of a silane coupling agent, the surface of the heat sink is hydroxylated by immersing the heat sink in an alkali solution, then cleaning with water and drying.

In a second aspect, the present invention also provides a semiconductor device package having at least one built-in semiconductor device and an embedded metal heat sink for dissipating heat generated by said semiconductor device in a mould resin, the surface of said heat sink being provided with a layer of a silane coupling agent.

In a preferred package the heat sink takes the form of a simple shape such as a disk. This reduces the manufacturing costs of the semiconductor packaging.

Since the surface of the metal heat sink is hydroxylated, then a layer of a silane coupling agent is applied on the surface of this heat sink, and the heat sink is embedded in a mould resin by casting a resin material around the heat sink, adhesion between the heat sink and the mould is enhanced.

Since adhesion is thus enhanced, the thermal stress resistance and moisture resistance of the semiconductor packaging is improved. As the results, reliability equivalent to or higher than other semiconductor packaging with embedded heat sinks is obtained, and the deterioration of thermal properties such as heat dissipation is prevented for a long period.

An embodiment of the invention will now be described, by way of example, with reference to Figures 1 and 2. As detailed below, Figures 3 to 5 relate to prior art packaging techniques.

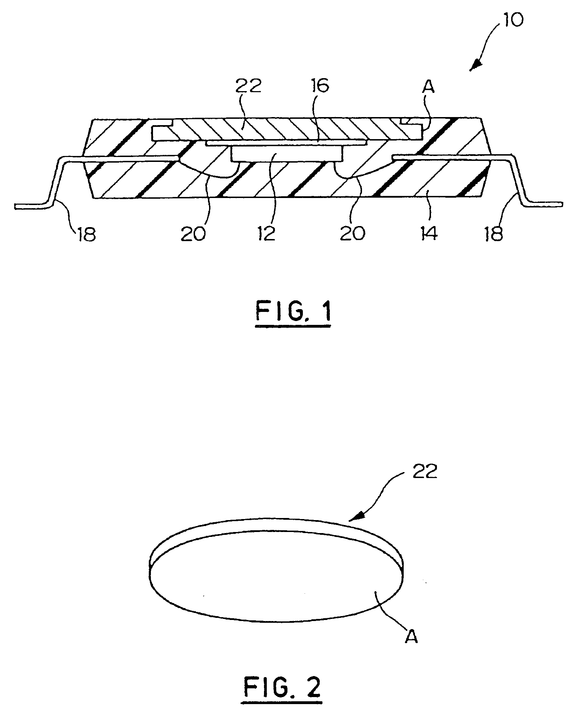

Figure 1 is a cross sectional view illustrating an embodiment of a semiconductor packaging produced by the method for producing a semiconductor packaging according to the present invention;
Figure 2 is a perspective view of a heat sink used in an embodiment of the method for producing a semiconductor packaging according to the present invention;
Figure 3 is a diagram illustrating the method for producing the first example of prior art semiconductor packaging; (a) is a cross sectional view of the semiconductor packaging before attaching the heat sink, and (b) is a cross sectional view of the semiconductor packaging after attaching the heat sink;
Figure 4 is a diagram illustrating the method for producing the second example of prior art semiconductor packaging; (a) is a diagram of a heat spreader bonded to lead frames with double-sided adhesive tapes, and (b) is a cross sectional view of the finished semiconductor packaging; and
Figure 5 is a diagram illustrating a heat sink used in the method for producing the third example of prior art semiconductor packaging; (a) is a top view of the heat sink, and (b) is a side view of the same heat sink.

The following reference numerals are employed in the description and associated drawings:
- 10: Semiconductor packaging
- 12: Semiconductor chip
- 14: Mould
- 22: Heat sink

As Figure 1 shows, a chip 12, which is a semiconductor device, is encapsulated in the central portion of a plastic mould 14 constituting the outer frame of the semiconductor packaging 10 of the present invention, in the state where the chip 12 is bonded at the upper end to the die pad 16 formed in a plate shape, and the ends of lead frames 18 whose other ends are projected out of the mould 14 are connected to the chip 12 through wires 20.

A disc-shaped heat sink 22 (shown in Figure 2) consisting of aluminum, copper or an alloy of these metals, having a high thermal conductivity, is provided in the mould 14 above the die pad 16, in the state where the upper surface is exposed to the outside. The die pad 16, consisting of the same metal material as the lead frame 18, is used.

By the above structure, when this semiconductor packaging 10 is used, a high heat dissipation is secured by the heat sink 22 a part of which is exposed to the outside.

Next, the surface treatment of this heat sink 22 and the manufacture of the semiconductor packaging 10 are described.

In order to simplify this treatment, the heat sink 22 is hydroxylated by immersing it in an alkali solution listed below, cleaning with water and drying. The immersion in the alkali solution is also possible by using the method used in ordinary electroplating.

Examples of alkali solutions used here include (1), (2) and (3) below so that their pH is 10 or lower in the temperature range between room temperature and 70°C.
(1) Sodium hydroxide: 10-40 g/l
(2) Sodium carbonate: 15-25 g/l
(3) Sodium phosphate: 12-22 g/l

These are examples, and any solution containing hydroxyl groups can be used.

Thereafter, a diluted silane coupling agent is applied to the surface of the heat sink 22 by coating, spraying or dipping, and the heat sink 22 is dried to provide a layer A of the silane coupling agent on the surface of the heat sink 22.

The examples of silane coupling agents used in the method of the present invention include (1), (2), (3) and (4) below when the reactivity with epoxy resins usually composing the mould 14.
(1) γ-aminopropyl-triethoxysilane
(2) N-β-(aminoethyl)-γ-aminopropyl-trimethoxysilane
(3) β-(3,4-epoxy-cyclohexyl)-ethyltrimethoxysilane
(4) γ-glycidoxy-propyltrimethoxysilane

An example of dilution is the use of 1 part of a silane coupling agent, 9 parts of water, 80 parts of isopropyl alcohol, and 10 parts of methyl alcohol. The heat sink 22 is dried in a temperature range of 50-120°C.

Furthermore, a chip 12 bonded to a die pad 16 and lead frames 18 connected to the chip 12 with wires 20 are placed in a die (not shown), the heat sink 22 on which a layer A of a silane coupling agent is formed after hydroxylation is placed in the same die, and a mould 14 is moulded using a resin material. By this a semiconductor packaging 10 having the structure as shown in Figure 1 is manufactured.

As the result, even the simple disc-shaped heat sink 22 has a sufficient adhesion with the mould 14, and even if a thermal stress due to heat cycles is applied, the heat sink 22 is not separated from the mould 14, or no gap is formed between the mould 14 and the heat sink 22. Consequently, moisture resistance is improved, the reliability of the semiconductor packaging 10 increases, and the deterioration of thermal properties such as heat dissipation can be prevented for a long period.

Since the heat sink 22 has a simple shape, a large number of heat sinks 22 can be produced by low cost machining. Furthermore, on moulding the mould resin 14, since most of conventional manufacturing processes can be used except only placing the heat sink 22 in the mould 14, the mould 14 can be moulded at low costs.

By reducing the fabricating costs for the heat sink 22 and the moulding costs, therefore, the manufacturing costs of the semiconductor packaging 10 can be reduced.

If the adhesion of a silane coupling agent is enough to bond between the heat sink 22 and the mould 14, the alkali immersion process may be omitted.

Although synthetic resins used as the material of the mould 14 include for example epoxy resin, those skilled in the art will understand that other synthetic resins may also be used.

## Claims

1. A method for producing a semiconductor package incorporating at least one semiconductor device comprising the steps of:
hydroxylating the surface of a metal heat sink to be used in dissipating heat generated by said at least one semiconductor device, then depositing a layer of a silane coupling agent on the surface of said heat sink, and
embedding said heat sink in a mould resin by casting a resin material around said heat sink.

2. The method as set forth in Claim 1, wherein the step of depositing a layer of a silane coupling agent on the surface of said heat sink comprises depositing a layer of a silane coupling agent containing one selected from the group of γ-aminopropyl-triethoxysilane, N-β-(aminoethyl)-γ-aminopropyl-trimethoxysilane, β-(3,4-epoxy-cyclohexyl)-ethyltrimethoxysilane, and γ-glycidoxy-propyltrimethoxysilane.

3. The method as set forth in Claim 1 or Claim 2, wherein the step of hydroxylating the surface of said heat sink is performed by immersing said heat sink in an alkali solution, then cleaning said heat sink with water and drying.

4. A semiconductor device package comprising at least one semiconductor device thermally connected to an embedded metal heat sink for dissipating heat generated by said semiconductor device in a mould resin,
the surface of said heat sink being provided with a layer of a silane coupling agent.

5. The semiconductor package as set forth in Claim 4, the layer of a silane coupling agent containing one selected from the group of γ-aminopropyl-triethoxysilane, N-β-(aminoethyl)-γ-aminopropyl-trimethoxysilane, β-(3,4-epoxy-cyclohexyl)-ethyltrimethoxysilane, and γ-glycidoxy-propyltrimethoxysilane.

6. The semiconductor package as set forth in Claim 4 or Claim 5 wherein said heat sink is substantially disc shaped.
